# FASCICULE DE BREVET EUROPEEN

(11) **EP 1 131 784 B1**
(45) Date de publication et mention de la délivrance du brevet: **12.03.2003**
(21) Numéro de dépôt: 99950806.2
(22) Date de dépôt: 21.10.1999
(51) Int. Cl.: G06K 19/077

(54) **CIRCUIT ELECTRONIQUE AUTOCOLLANT**
SELBSTKLEBENDE ELEKTRONISCHE SCHALTUNG
SELF-ADHESIVE ELECTRONIC CIRCUIT

(30) Priorité: 23.10.1998 FR 9813545
(43) Date de publication de la demande: 12.09.2001
(73) Titulaire: STMicroelectronics S.A., 92120 Montrouge (FR)
(72) Inventeur: ROYER, Guillaume, F-13100 Aix en Provence (FR)
(74) Mandataire: de Beaumont, Michel
(86) Numéro de dépôt international: FR9902564
(87) Numéro de publication internationale: WO00025266

(56) Documents cités:
- DE-A- 4 431 606
- FR-A- 2 760 113

## Description

La présente invention concerne la fixation de circuits électroniques.

Des étiquettes portant des indications lisibles par un périphérique d'ordinateur, comme un code barre lisible par un analyseur optique, sont récemment apparues. Un tel système permet d'identifier rapidement un produit étiqueté. Pour lire une étiquette, il faut qu'elle soit en face de l'analyseur, ce qui implique une manipulation du produit dont on veut lire l'étiquette. Enfin, les informations contenues dans le code barre ne sont pas modifiables.

Une étiquette électronique comportant une antenne connectée à une puce permet, au moyen d'une antenne électromagnétique couplée à un système d'ordinateur, de lire et écrire des informations dans la puce. Il n'est pas nécessaire que l'étiquette électronique soit en face de l'antenne pour que l'échange d'information soit possible. Ce type d'étiquette présente de nombreux avantages car on peut y mémoriser une grande quantité d'informations réinscriptibles immédiatement, sans pour cela devoir manipuler l'objet dont on lit l'étiquette. Cependant, les dispositifs électroniques classiques comportant une puce sont généralement trop rigides, trop épais et trop coûteux pour permettre de réaliser une étiquette électronique robuste, peu encombrante et bon marché. De plus, la fixation de l'étiquette à l'objet est toujours un problème.

La présente invention permet de produire simplement à faible coût des étiquettes électroniques autocollantes souples, minces et faciles à poser, par machine ou manuellement.

Pour atteindre cet objet, la présente invention prévoit un circuit électronique comprenant une embase plane, une antenne fixée sur une première face de l'embase, une puce connectée à l'antenne et un ruban adhésif double face collé sur l'une des faces de l'embase, une découpe étant ménagée dans le ruban adhésif double face et la puce étant disposée au moins partiellement dans ladite découpe.

Selon un mode de réalisation de la présente invention, la puce est collée sur la première face de l'embase et reliée à l'antenne par des fils de connexion, les fils et la puce étant recouverts d'une goutte de résine.

Selon un mode de réalisation de la présente invention, la face gravée de la puce est tournée vers la première face de l'embase, et la puce est connectée à l'antenne par des billes de soudure.

Selon un mode de réalisation de la présente invention, la face gravée de la puce est tournée vers le dos de la première face de l'embase, la puce est placée dans une découpe pratiquée à travers l'embase et la puce est connectée à l'antenne par des billes de soudure, la puce étant fixée à l'embase par une goutte de résine.

Selon un mode de réalisation de la présente invention, la face gravée de la puce est tournée vers le dos de la première face de l'embase et la puce est connectée à l'antenne par des billes de soudure situées dans des découpes de connexion traversant l'embase, la puce étant fixée à l'embase par une goutte de résine.

Selon un mode de réalisation de la présente invention, l'embase est constituée d'une feuille souple.

Selon un mode de réalisation de la présente invention, la face de l'embase ne recevant pas l'adhésif double face est prévue pour recevoir l'impression d'un motif, d'un texte ou d'un code.

La présente invention vise également un procédé de fabrication d'un circuit électronique tel que susmentionné, qui comprend les étapes suivantes : former un rectangle du ruban adhésif double face comprenant une découpe, coller le rectangle d'adhésif sur un film protecteur de conditionnement, décoller le rectangle d'adhésif du film protecteur, et l'assembler sur l'embase de telle manière que la puce est disposée au moins partiellement dans ladite découpe.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente une vue de dessus d'une étiquette selon un premier mode de réalisation de la présente invention ;
la figure 2 représente une vue en coupe de l'étiquette de la figure 1 ;
la figure 3 représente une vue de dessus d'une étiquette réalisée selon un deuxième mode de réalisation de la présente invention ;
la figure 4 représente une vue en coupe de l'étiquette de la figure 3 ;
la figure 5 représente une vue de dessus d'une étiquette réalisée selon un troisième mode de réalisation de la présente invention ;
la figure 6 représente une vue en coupe de l'étiquette de la figure 5 ;
la figure 7 représente une vue de dessus d'une étiquette réalisée selon un quatrième mode de réalisation de la présente invention ;
la figure 8 représente une vue en coupe de l'étiquette de la figure 7 ;
la figure 9 représente une vue en coupe d'une étiquette selon un cinquième mode de réalisation de la présente invention ;
la figure 10 illustre un procédé de fabrication d'étiquettes électroniques autocollantes selon un mode de réalisation de la présente invention ; et
la figure 11 représente schématiquement un conditionnement final d'étiquettes selon la présente invention.

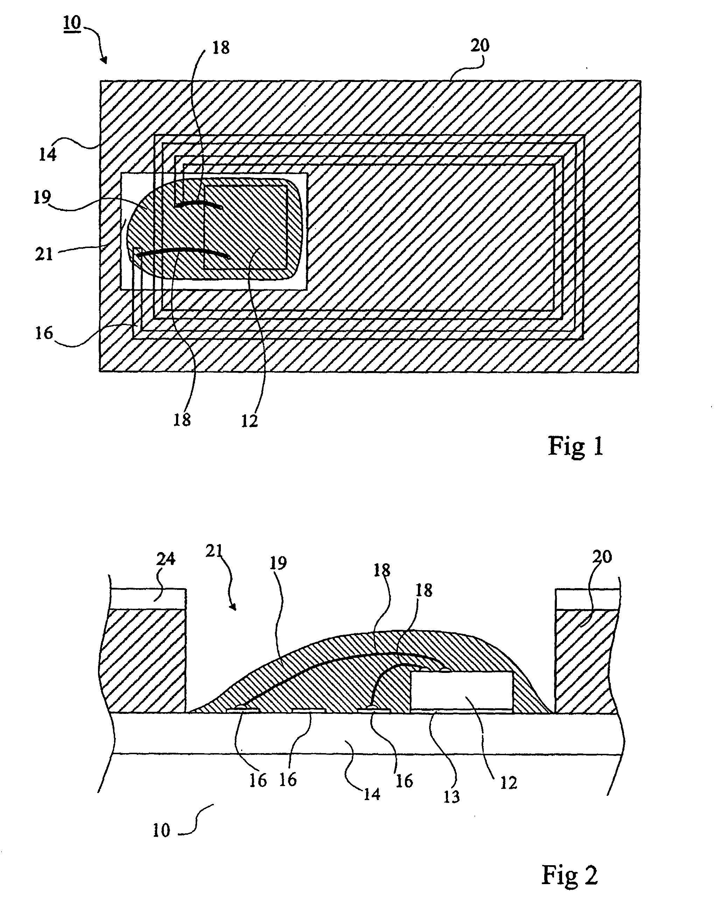

Les mêmes références désignent de mêmes éléments dans les diverses figures. Les figures 1 et 2 représentent en vue de dessus et en coupe une étiquette 10 selon un premier mode de réalisation de la présente invention. Cette étiquette comporte une puce 12 fixée par une couche de colle 13 sur une première face d'une embase 14. Une antenne 16 est également fixée à la première face de l'embase 14. La puce 12 est reliée électriquement à l'antenne 16 par des fils de connexion 18. La puce et les fils sont pris dans une goutte de résine de protection 19. On désignera par la suite par "adhésif double face" un segment d'un ruban plastique traité de manière classique pour être adhésif sur ses deux faces, ou une bande de colle solide. Une première face d'un adhésif double face 20 percé d'une découpe 21 est collée sur la première face de l'embase 14 de manière à recouvrir la première face à l'exception du voisinage de la goutte de résine 19, situé dans la découpe 21. Une feuille pelable 24 recouvre la seconde face de l'adhésif double face 20.

La puce 12 peut être collée à l'embase au moyen d'une colle, époxy ou autre, et les fils de connexion 18 peuvent être fixés par une machine classique de câblage. L'antenne 16 peut être formée sur l'embase de manière connue par dépôt métallique puis gravure. La goutte de résine peut être formée par enrobage, par moulage, ou par cloisonnement. L'embase 14 est en une matière souple de faible épaisseur, par exemple un morceau de feuille de polyester.

L'adhésif double face est plus épais que la goutte de résine et il constitue à la fois la partie adhésive de l'étiquette autocollante et le boîtier protecteur de la puce 12. L'adhésif double face est réalisé en matière souple légèrement élastique pour que l'étiquette autocollante soit propre à être collée sur une surface non plane, et soit résistante aux vibrations et aux chocs. La colle dont l'adhésif double face est enduit est une colle forte permettant un collage durable et sûr. On pourra utiliser des adhésifs double face couramment disponibles dans le commerce, par exemple auprès de la société 3M, sous le nom VHB.

A titre d'exemple, l'épaisseur de l'embase 14 peut être de 75 µm, celle de l'antenne 16 de 17 µm, celle de la colle 13 de 20 µm, celle de la puce 12 de 180 µm, celle de la goutte 19 de 300 µm et celle de l'adhésif double face 20 de 400 µm. Ainsi, selon ce mode de réalisation, l'étiquette 10 a une épaisseur d'environ 500 µm. L'épaisseur de l'adhésif double face 20 est ici très supérieure à la hauteur de la goutte 19 pour qu'une variation de la hauteur de la goutte lors de sa formation puisse être tolérée.

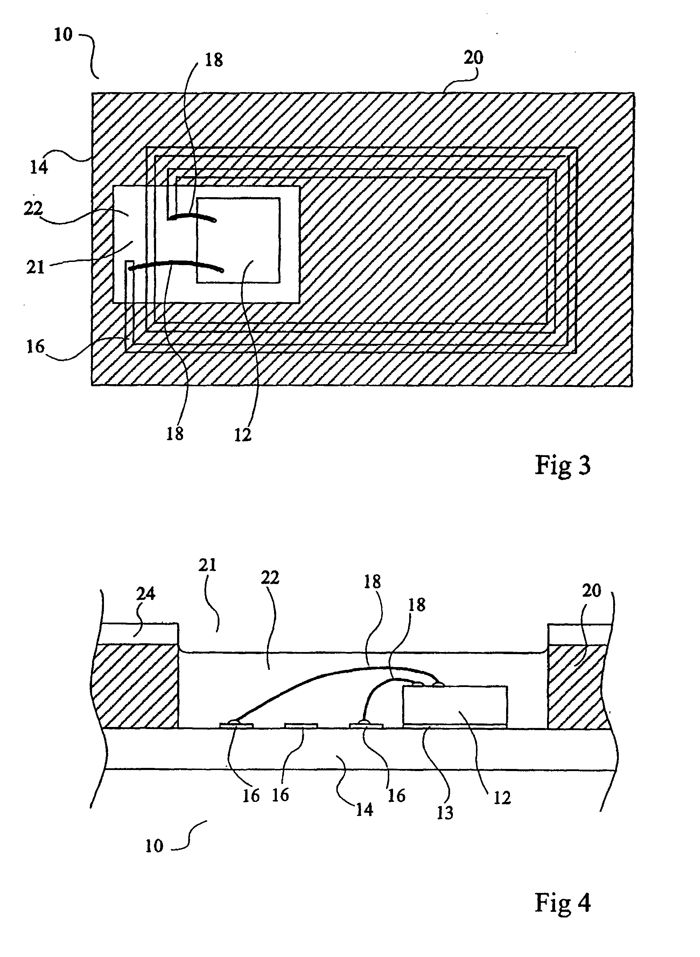

Les figures 3 et 4 représentent en vue de dessus et en coupe une étiquette 10 selon un deuxième mode de réalisation de la présente invention. Dans ce mode de réalisation, les fils de connexion 18 et la puce 12 sont protégés par une goutte de résine 22 formée en remplissant la découpe 21 de résine. La formation de la goutte 22 est ici plus rapide que selon le mode de réalisation précédent. En effet, les procédés de formation de la goutte 19 cités en relation avec les figures 1 et 2 sont lents, alors qu'il suffit ici de remplir la découpe 21 de résine. Dans ce mode de réalisation, en plus des fonctions mentionnées précédemment, la découpe 21 dans l'adhésif double face sert à limiter l'étalement de la résine, qui peut être choisie très fluide.

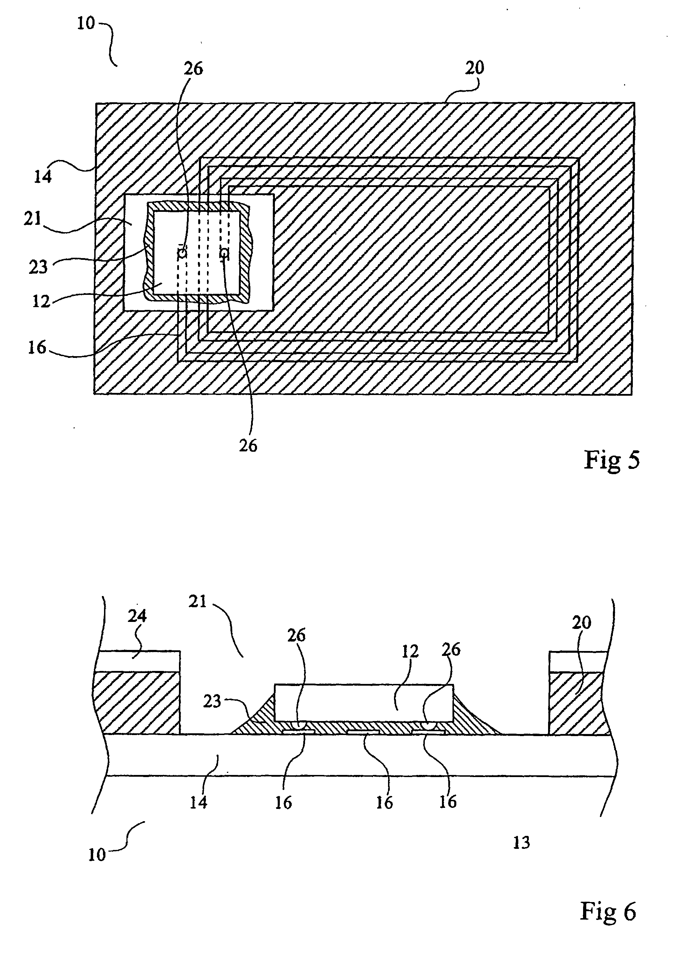

Les figures 5 et 6 représentent en vue de dessus et en coupe une étiquette 10 selon un troisième mode de réalisation de la présente invention. La face avant ou face gravée de la puce 12, c'est-à-dire la face ayant reçu les divers traitement destinés à la formation d'un circuit intégré en technologie planar, est placée contre la première face du support 14 selon un mode de montage dit flip-chip, de manière à être connectée électriquement à l'antenne 16 par l'intermédiaire de billes de soudure 26. Une couronne de résine 23 est formée sur le pourtour de la puce de manière à sceller la puce 12 sur l'embase 14. Ce mode de réalisation nécessite un assemblage par billes de soudure, délicat à réaliser, mais il permet de diminuer l'épaisseur de l'étiquette 10.

A titre d'exemple, on considère que les billes de soudure ont une épaisseur sensiblement constante de 20 µm, et qu'on peut prévoir une marge de 10 µm seulement pour la profondeur de la découpe 21. Avec une épaisseur de puce 12 de 180 µm, on peut utiliser un adhésif double face d'une épaisseur de 210 µm. Si l'épaisseur totale de l'embase 14 et de l'antenne 16 est proche de 95 µm, on obtient une étiquette 10 d'une épaisseur proche de 300 µm seulement.

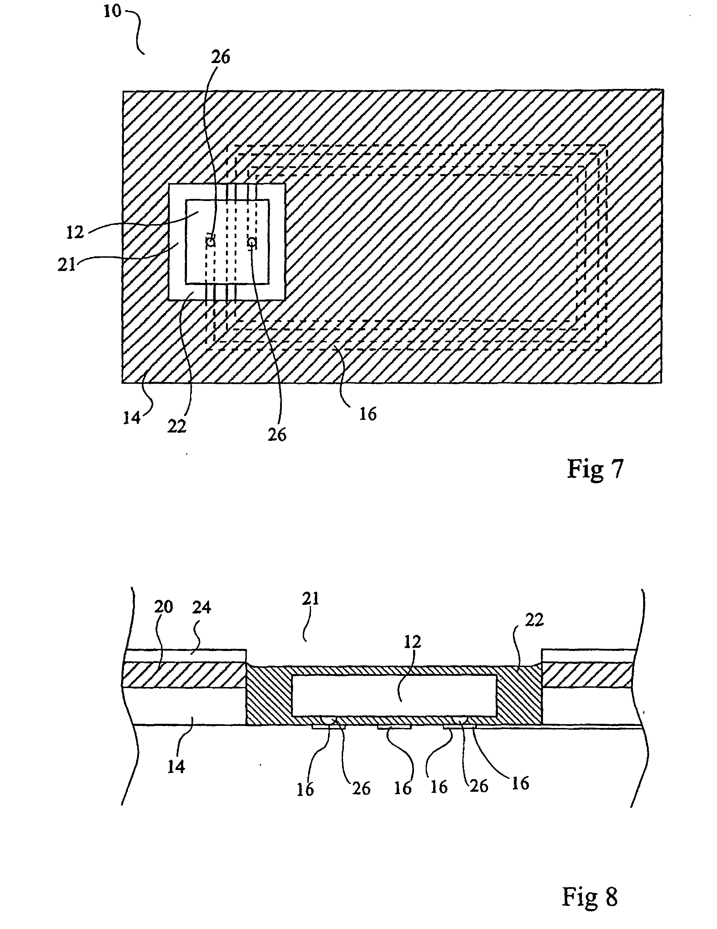

Les figures 7 et 8 représentent en vue de dessus et en coupe une étiquette 10 selon un quatrième mode de réalisation de la présente invention. L'antenne 16 est ici située sur la face de l'embase 14 qui n'est pas recouverte par l'adhésif double face 20. En outre, l'embase 14 est traversée par une découpe 21 qui prolonge sensiblement la découpe 21 de l'adhésif double face 20. La puce 12 est située dans la découpe 21, tournée face gravée vers le dos de l'antenne 16 et connectée au dos de l'antenne par des billes de soudure 26. La découpe 21, dans l'embase 14 et l'adhésif double face 20, est remplie par une goutte de résine 22. Ce mode de réalisation nécessite une découpe 21 de l'embase puis une connexion par billes de soudure, qui sont des opérations délicates, mais il permet de diminuer l'épaisseur de l'étiquette 10.

A titre d'exemple, si l'épaisseur de l'embase est de 75 µm, l'épaisseur de l'antenne proche de 20 µm, si l'épaisseur de la puce 12 est de 180 µm, et si l'épaisseur des billes de soudure 26 est d'environ 20 µm, on peut utiliser un adhésif d'environ 135 µm et obtenir une étiquette 10 d'une épaisseur proche de 230 µm. Cette épaisseur est sensiblement celle d'une étiquette autocollante non électronique classique.

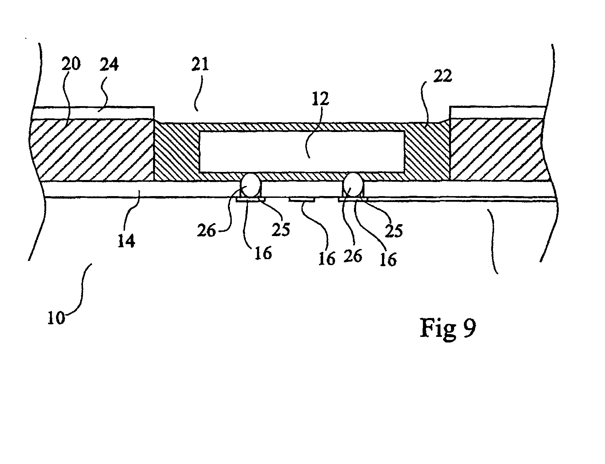

La figure 9 représente en coupe une étiquette 10 selon un cinquième mode de réalisation de la présente invention. L'antenne 16 est située sur la même face de l'embase 14 qu'en figures 7 et 8. La puce 12 est située dans la découpe 21 de l'adhésif double face 20, tournée face gravée vers le dos de l'antenne 16 et connectée au dos de l'antenne par des billes de soudure 26 à travers des découpes de connexion 25 pratiquées dans l'embase 14.

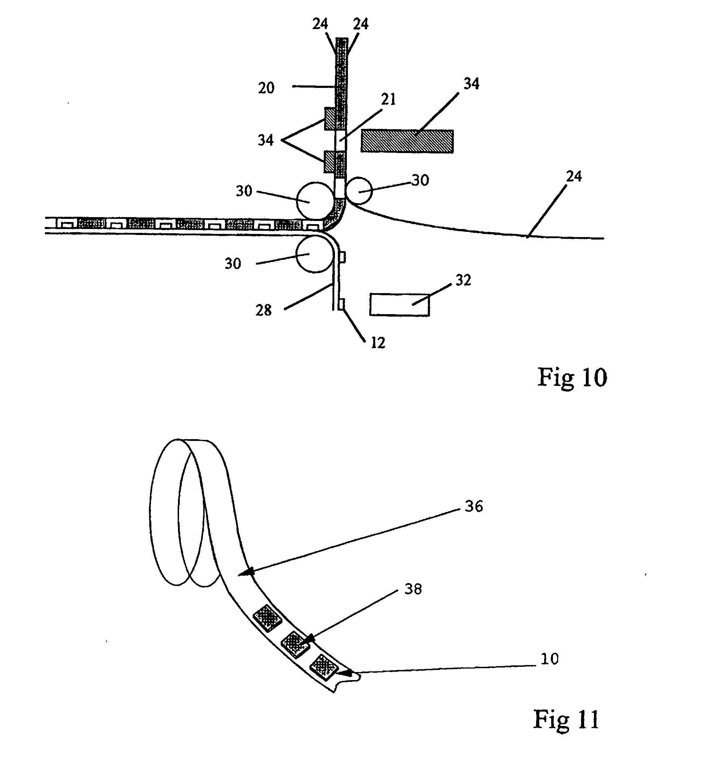

La figure 10 illustre un procédé de fabrication d'étiquettes autocollantes selon le mode de réalisation décrit en relation avec les figures 3 et 4. Une série d'antennes (non représentées) a été formée sur une bande indexée mécaniquement 28 destinée à être découpée en une série d'embases. Une puce 12 a été collée au niveau de chaque antenne sur la bande indexée, qui est fournie à une machine de laminage 30. La machine reçoit également un adhésif double face 20 recouvert d'un film protecteur 24 sur ses deux faces. Un capteur 32 repère la position de chaque puce 12 et commande un poinçon 34 pour former dans l'adhésif double face une découpe 21 correspondant à cette position. Le film protecteur 24 est retiré d'une première face de l'adhésif double face 20 découpé, qui est laminé et collé sur la bande indexée. Chaque puce 12 est ensuite connectée à l'antenne correspondante par des fils de connexion (non représentés), à la suite de quoi la découpe 21 est remplie par une goutte de résine (non représentée). Après assemblage des étiquettes, la bande indexée est coupée pour former les étiquettes, chaque étiquette est testée électromagnétiquement et les étiquettes fonctionnelles sont séparées de leur pellicule de protection pour être placées sur une bande de conditionnement.

Une variante de procédé de fabrication consiste à utiliser des rectangles d'adhésif double face 20 prédécoupés (séparés les uns des autres et comportant la découpe 21), par exemple par le fabricant d'adhésif. Les rectangles d'adhésif double face 20 sont alors livrés maintenus ensemble par une bande de film protecteur 24, et ils sont décollés un à un du film protecteur, par une machine ou par un opérateur, pour être collés aux embases. Les étiquettes pourront alors être fabriquées selon le mode de réalisation des figures 1 et 2. Dans ce cas, on formera les connexions 18 et la goutte de résine 19 de protection de la puce et des connexions avant de coller l'adhésif double face sur l'embase 14. Le test électromagnétique de chaque puce 12 connectée peut ainsi avoir lieu avant de coller l'adhésif double face, ce qui implique qu'une pièce défectueuse rejetée représente une perte moins importante. On pourra également selon cette variante fabriquer les étiquettes des figures 3 à 9.

La figure 11 représente une bande de conditionnement 36 comportant des étiquettes 10 dont la seconde face a été recouverte d'un logo ou d'un code 38, prêtes à la commercialisation.

Bien entendu, la présente invention est susceptible de diverses variantes et modifications qui apparaîtront à l'homme du métier. On peut par exemple dans le mode de réalisation des figures 1 et 2 former une cavité dans la moitié supérieure de l'épaisseur de l'embase 14 pour recevoir la puce 12, et ainsi diminuer l'épaisseur de l'étiquette et faciliter la formation de la goutte 19. D'autre part, la face de l'embase qui n'est pas collée à l'adhésif double face peut être peinte ou imprimée ou être recouverte d'une matière facile à peindre ou à imprimer. D'autre part, les descriptions précédentes concernent des étiquettes autocollantes, mais la présente invention peut également s'appliquer à tout circuit électronique autocollant, par exemple un capteur. A ce titre, on peut par exemple dans le mode de réalisation des figures 7 et 8, remplacer la résine de protection 22, classiquement .opaque, par une résine de protection transparente si la puce comporte des circuits sensibles à la lumière tels que des circuits photovoltaïques ou à couplage de charge. On pourra alors donner à une partie de la goutte de résine 22 la forme d'une lentille pour une meilleure réception de la lumière par la puce.

## Revendications

1. Circuit électronique comprenant une embase plane (14), une antenne (16) fixée sur une première face de l'embase et une puce (12) connectée à l'antenne, **caractérisé en ce qu'**un ruban adhésif double face (20) est collé sur l'une des faces de l'embase, une découpe (21) étant ménagée dans le ruban adhésif double face, la puce étant disposée au moins partiellement dans ladite découpe.

2. Circuit électronique selon la revendication 1, **caractérisé en ce que** la puce est collée sur la première face de l'embase et reliée à l'antenne par des fils de connexion (18), les fils et la puce étant recouverts d'une goutte de résine (19, 22).

3. Circuit électronique selon la revendication 1, **caractérisé en ce que** la face gravée de la puce est tournée vers la première face de l'embase, et **en ce que** la puce est connectée à l'antenne par des billes de soudure (26).

4. Circuit électronique selon la revendication 1, **caractérisé en ce que** la face gravée de la puce est tournée vers le dos de la première face de l'embase, **en ce que** la puce est placée dans une découpe (21) pratiquée à travers l'embase et **en ce que** la puce est connectée à l'antenne par des billes de soudure (26), la puce étant fixée à l'embase par une goutte de résine (22).

5. Circuit électronique selon la revendication 1, **caractérisé en ce que** la face gravée de la puce est tournée vers le dos de la première face de l'embase et **en ce que** la puce est connectée à l'antenne par des billes de soudure (26) situées dans des découpes de connexion (25) traversant l'embase (14), la puce étant fixée à l'embase par une goutte de résine (22).

6. Circuit électronique selon l'une quelconque des revendications précédentes, **caractérisé en ce que** l'embase (14) est constituée d'une feuille souple.

7. Circuit électronique selon l'une quelconque des revendications précédentes, **caractérisé en ce que** la face de l'embase ne recevant pas l'adhésif double face est prévue pour recevoir l'impression d'un motif, d'un texte ou d'un code (38).

8. Procédé de fabrication d'un circuit selon la revendication 1, **caractérisé en ce que** l'assemblage du ruban adhésif double face sur l'embase comprend les étapes suivantes :
former un rectangle de ruban adhésif double face (20) comprenant une découpe (21),
coller le rectangle d'adhésif sur un film protecteur (24) de conditionnement,
décoller le rectangle d'adhésif du film protecteur, et l'assembler sur l'embase (14) de telle manière que la puce est disposée au moins partiellement dans ladite découpe.

## Claims

1. An electronic circuit including a planar base (14), an antenna (16) attached on a first surface of the base, and a chip (12) connected to the antenna, **characterized in that** a double faced adhesive tape (20) is glued on one of the base surfaces, a slot (21) being made in the double faced adhesive tape and the chip being arranged at least partially in this slot.

2. The electronic circuit of claim 1, **characterized in that** the chip is glued on the first surface of the base and is connected to the antenna by connection wires (18), the wires and the chip being covered with a drop of resin (19, 22).

3. The electronic circuit of claim 1, **characterized in that** the etched surface of the chip faces the first surface of the base, and the chip is connected to the antenna by welding beads (26).

4. The electronic circuit of claim 1, **characterized in that** the etched surface of the chip faces the back of the first surface of the base, the chip is placed in a slot (21) made through the base, and the chip is connected to the antenna by welding beads (26), the chip being attached to the base by a drop of resin (22).

5. The electronic circuit of claim 1, **characterized in that** the etched surface of the chip faces the back of the first surface of the base and the chip is connected to the antenna by welding beads (26) located in connection slots (25) going through the base (14), the chip being attached to the base by a drop of resin (22).

6. The electronic circuit of any of the preceding claims, **characterized in that** the base (14) is made of a flexible sheet.

7. The electronic circuit of any of the preceding claims, **characterized in that** the surface of the base which does not receive the double faced adhesive is provided to receive the printing of a pattern, of a text or of a code (38).

8. A method of manufacturing the circuit of claim 1, **characterized in that** the attachment of the double faced adhesive tape on the base includes the steps of:
forming a rectangle of double faced adhesive (20) including a slot (21),
gluing the adhesive rectangle on a packaging protective film (24),
ungluing the adhesive rectangle from the protective film, and assembling it on the base (14) so that the chip is at least partially accommodated in said slot.

## Patentansprüche

1. Elektronische Schaltung, mit einer ebenen Trägerbasis (14), einer auf einer ersten Fläche der Trägerbasis befestigten Antenne (16) und einem mit der Antenne verbundenen Chip (12), ***dadurch gekennzeichnet,* dass** auf eine der Flächen der Trägerbasis ein doppelseitig klebendes Klebeband (20) aufgeklebt ist, und dass in dem doppelseitig klebenden Klebeband eine Ausnehmung (21) vorgesehen, in welcher der Chip wenigstens teilseise angeordnet ist.

2. Elektronische Schaltung nach Anspruch 1, **dadurch gekennzeichnet, dass** der Chip auf der ersten Fläche der Trägerbasis aufgeklebt und mit der Antenne über Verbindungsdrähte (18) verbunden ist, und dass die Drähte und der Chip mit einem Harztropfen (19,22) überdeckt sind.

3. Elektronische Schaltung nach Anspruch 1, **dadurch gekennzeichnet, dass** die geätzte Oberfläche des Chips der ersten Fläche der Trägerbasis zugewandt ist und dass der Chip mit der Antenne mittels Lotkügelchen bzw.-perlen (26) verbunden ist.

4. Elektronische Schaltung nach Anspruch 1, **dadurch gekennzeichnet, dass** die geätzte Oberfläche des Chips der Rückseite der ersten Fläche der Trägerbasis zugewandt ist, dass der Chip in einer durch die Trägerbasis hindurchgehenden Ausnehmung Ausnehmung (21) angeordnet ist, dass der Chip mit der Antenne mittels Lotkügelchen bzw. - perlen (26) verbunden ist, und dass der Chip an der Trägerbasis durch einen Harztropfen (22) befestigt ist.

5. Elektronische Schaltung nach Anspruch 1, **dadurch gekennzeichnet, dass** die geätzte Oberfläche des Chips der Rückseite der ersten Fläche der Trägerbasis zugewandt ist, dass der Chip mit der Antenne durch Lotkügelchen bzw. -perlen (26) verbunden ist, die in die Trägerbasis durchsetzenden Verbindungsausnehmungen (25) liegen, und dass der Chip mittels eines Harztropfens befestigt ist.

6. Elektronische Schaltung nach einem der vorhergehenden Ansprüche, **dadurch gekennzeichnet, dass** die Trägerbasis (14) durch eine biegsame Folie gebildet wird.

7. Elektronische Schaltung nach einem der vorhergehenden Ansprüche, **dadurch gekennzeichnet, dass** die nicht das doppelseitig klebende Klebeband aufnehmende Fläche der Trägerbasis zur Aufnahme einer Bedruckung mit einem Motiv, einem Text oder einem Code vorgesehen ist.

8. Verfahren zur Herstellung einer Schaltung nach Anspruch 1, **dadurch gekennzeichnet, dass** die Anbringung des doppelseitig klebenden Klebebands auf der Trägerbasis die folgenden Verfahrensschritte bzw. -stufen umfasst:
Bilden eines Rechtecks aus einem doppelseitig klebenden Klebeband (20),
Aufkleben des Klebeband-Rechtecks auf einen Schutz- und Verpackungsfilm (24),
Lösen der Verklebung des Klebebandrechtecks von dem Schutzfilm und Aufbringen auf der Trägerbasis (14) in solcher Weise, dass der Chip wenigstens teilweise in der genannten Ausnehmung angeordnet ist.
